# DEMANDE DE BREVET EUROPEEN

(11) **EP 2 256 798 A1**
(43) Date de publication de la demande: **01.12.2010**
(21) Numéro de dépôt: 10177181.4
(22) Date de dépôt: 12.07.2007
(51) Int. Cl.: H01L 21/762

(54) **Traitement thermique de stabilisation d'interface de collage**

(30) Priorité: 13.07.2006 FR 0606440
(62) Demande divisionnaire de: 07112311.1
(71) Demandeur: S.O.I. Tec Silicon on Insulator Technologies, 38190 Bernin (FR)
(72) Inventeur: Neyret, Eric, 30330, Gaujac (FR); Kerdiles, Sébastien, 38330, Saint-Ismier (FR)
(74) Mandataire: Collin, Jérôme

(57) **Abrégé**

L'invention concerne un procédé de réalisation d'une structure comprenant une couche mince de matériau semi-conducteur sur un substrat, comportant les étapes de:
- création d'une zone de fragilisation dans l'épaisseur du substrat donneur;
- collage du substrat donneur avec un substrat support ;
- détachement du substrat donneur au niveau de la zone de fragilisation, pour transférer une partie du substrat donneur sur le substrat support et former la couche mince sur celui-ci ;
- traitement thermique de la structure obtenue après détachement pour stabiliser l'interface de collage entre la couche mince et le substrat support, réalisé de manière à éviter l'apparition de lignes de glissement dans la couche mince.

## Description

L'invention concerne un procédé de réalisation d'une structure comprenant une couche mince de matériau semi-conducteur sur un substrat, comportant les étapes de:
- création d'une zone de fragilisation dans l'épaisseur d'un substrat donneur;
- collage du substrat donneur avec un substrat support ;
- détachement du substrat donneur au niveau de la zone de fragilisation, pour transférer une partie du substrat donneur sur le substrat support et former la couche mince sur celui-ci ;
- traitement thermique de la structure comprenant la couche mince sur le substrat support pour stabiliser l'interface de collage entre la couche mince et le substrat support.

Et l'invention concerne les structures obtenues par un tel procédé.

Des procédés du type mentionné ci-dessus sont déjà connus ; il s'agit par exemple des procédés de type Smart Cut™, ces derniers correspondant à un mode préféré de mise en oeuvre de l'invention.

On trouvera de plus amples détails concernant le procédé Smart Cut™ dans le document « Silicon-On-Insulator Technology : Materials to VLSI, 2nd Edition » de Jean-Pierre Colinge chez « Kluwer Academic Publishers », p.50 et 51.

De tels procédés permettent de réaliser de manière avantageuse des structures comprenant une couche mince de matériau semi-conducteur sur un substrat support, et notamment des structures de type SeOI (acronyme anglo-saxon de Semiconductor On Insulator, pour Semi-conducteur sur Isolant), dans lesquelles une couche isolante est intercalée entre la couche mince et le substrat support.

Les structures obtenues par de tels procédés sont utilisées pour des applications dans les domaines de la microélectronique, de l'optique et/ou de l'optronique, la couche mince servant typiquement de couche active pour la formation de composants.

Une stabilisation de l'interface de collage entre la couche mince et le substrat support s'avère nécessaire pour que la structure obtenue après détachement présente des propriétés mécaniques et électriques conformes aux exigences et spécifications des domaines d'application de l'invention.

Il s'agit notamment d'assurer une forte adhérence de la couche mince et du substrat support. En l'absence d'une telle adhérence, il existe un risque que les étapes ultérieures de formation de composants électroniques conduisent à une délamination de la couche mince au niveau de l'interface de collage.

On note à ce propos qu'en l'absence d'un traitement visant au moins à renforcer l'interface de collage, l'immersion dans un bain HF, directement après détachement, d'une structure formée suivant un procédé de type Smart Cut™, conduit au décollement de la couche mince en périphérie de la structure, sur une étendue radiale de plusieurs microns, voire même au décollement total de la couche mince.

Par ailleurs, la qualité du collage au niveau de l'interface de collage est susceptible de modifier le comportement des porteurs dans la couche mince. Afin d'assurer des performances électriques satisfaisantes et reproductibles, il est donc nécessaire que l'interface de collage soit stabilisée.

Il est possible de caractériser la correcte stabilisation d'une interface de collage couche mince/ substrat support en réalisant un clivage de la structure et une gravure de l'interface de collage à l'aide d'une solution de type Wright (pendant 10 secondes environ dans le cas d'une interface SiO₂/Si). Si l'interface n'est pas ou mal stabilisée, la gravure révèle un nombre important de défauts au niveau de l'interface, voire occasionne une gravure totale de l'interface. Au contraire, si l'interface est parfaitement stabilisée, aucun défaut n'apparaît.

Plus précisément, on considère dans la présente invention qu'une interface est correctement stabilisée dès lors que, par observation au Microscope Electronique à Balayage (MEB) de l'interface de collage après gravure Wright, par exemple sur trois champs chacun de largeur 3µm, on compte sur chaque champ un nombre de défauts inférieur ou égal à 1.

Une interface ne présentant aucun défaut/3 champs (de 3µm de large) sera alors considérée comme parfaitement stabilisée.

Une interface présentant 1 défaut/champ (de 3µm de large) sera quant à elle considérée comme faiblement stabilisée. Cette faible stabilisation s'avère toutefois satisfaisante dans les domaines d'application de l'invention.

Enfin, une interface présentant plus de 1 défaut/champ (de 3µm de large) sera considérée comme non stabilisée.

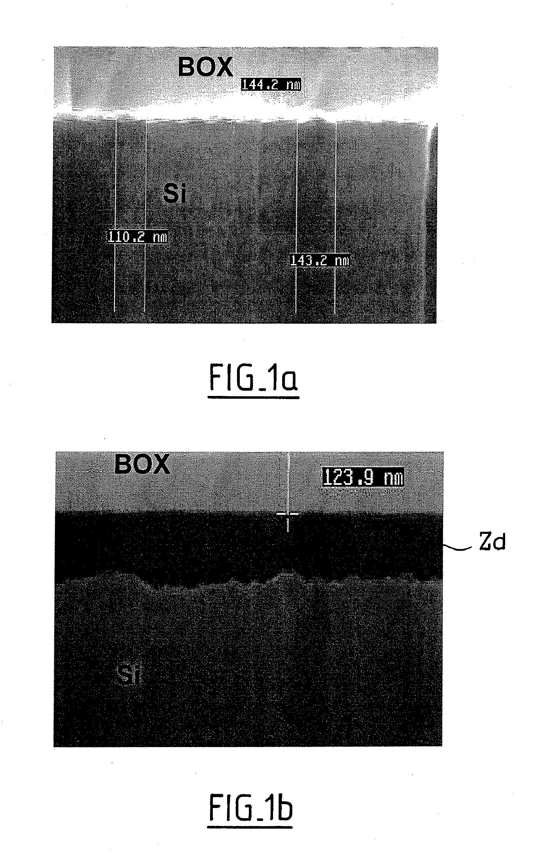

La figure 1a représente une interface oxyde BOX (selon les initiales de l'expression anglo-saxonne Buried OXide désignant un oxyde enterré) / silicium Si parfaitement stabilisée, ne présentant aucun défaut. En revanche, la figure 1b représente une interface oxyde BOX / silicium Si insuffisamment stabilisée présentant une zone défectueuse Zd entre la couche d'oxyde BOX et le substrat en Si, cette zone défectueuse Zd présentant des défauts révélés par la gravure Wright (en nombre supérieur à 1 défaut/champ observé au MEB).

Des solutions partielles au problème de la stabilisation de l'interface de collage ont été proposées. Celles-ci préconisent de réaliser un collage « fort » entre le substrat donneur et le substrat support, typiquement en réalisant un apport d'énergie thermique entre les étapes de collage et de détachement, ou encore en réalisant avant l'étape de collage un traitement de préparation de l'une et/ou l'autre des surfaces à coller.

Ces solutions permettent de renforcer le collage en venant augmenter l'énergie de collage entre le substrat donneur (et in fine de la couche mince) et le substrat support. Le renforcement du collage est un phénomène macroscopique et l'énergie de collage peut être mesurée mécaniquement, par exemple suivant la technique de la lame de Maszara.

On trouvera une description de cette technique dans l'article « Silicon-On-Insulator by Wafer Bonding : A Review » de W.P.Maszara in J.Electrochem. Soc., Vol. 138 ; No1. January 1991.

Mais ces solutions ne permettent pas de stabiliser l'interface de collage, la stabilisation étant un phénomène microscopique qui reflète l'établissement de liaisons atomiques (liaisons covalentes) entre les deux substrats assemblés, et cela de manière homogène sur l'ensemble de l'interface. Comme déjà mentionné ci-dessus, le non-établissement de ces liaisons, même très localement, peut être révélé chimiquement par gravure à l'aide de la solution Wright.

En d'autres termes, une interface de collage stabilisée présente nécessairement une forte énergie de collage, mais l'inverse n'est pas vrai.

Afin de réaliser une véritable stabilisation de l'interface de collage entre la couche mince et le substrat support, on réalise typiquement aujourd'hui un traitement thermique de la structure obtenue après détachement et transfert de la couche mince du substrat donneur vers le substrat support.

Ce traitement est plus précisément un recuit en four de la structure obtenue après détachement, à une température d'au moins 1000°C pendant plusieurs heures.

Ce type de traitement thermique longue durée sera désigné dans la suite de la description par « recuit de stabilisation ».

A titre d'exemple, dans le cas d'un collage SiO₂/Si (la couche de SiO₂ typiquement formée en surface du substrat donneur étant destinée à jouer le rôle de couche isolante entre la couche mince et le substrat support en Si), le recuit de stabilisation consiste à exposer la structure obtenue après détachement pendant deux heures à une température de 1100°C.

On pourra par ailleurs se reporter au document US 6,403,450 qui présente un exemple d'un tel recuit de stabilisation.

Toutefois la solution consistant à réaliser un tel recuit de stabilisation longue durée pour stabiliser l'interface de collage n'est pas totalement satisfaisante.

En premier lieu, la couche mince peut ne pas supporter un recuit de stabilisation en four pendant plusieurs heures. A titre d'exemple, un tel recuit appliqué à une couche mince en Silicium contraint est susceptible de générer des défauts de type dislocations dans l'épaisseur de la couche mince et d'occasionner en conséquence une relaxation de la contrainte.

Par ailleurs, le recuit de stabilisation est une opération longue (plusieurs heures), présentant par conséquent un budget thermique (couple température/durée) important. Le recuit de stabilisation vient donc compliquer le procédé de fabrication d'une structure comprenant une couche mince sur un substrat support et augmenter le coût de revient d'une telle structure.

En outre, le recuit de stabilisation est susceptible, du fait des installations nécessaires à sa mise en oeuvre, de dégrader la qualité de la structure couche mince sur substrat support. En effet, lorsque la température excède 1000°C, des défauts de type « slip lines » (lignes de glissement) peuvent être engendrés du fait de l'apparition de zones de contrainte typiquement localisées au niveau des extrémités des points de contact entre la structure et le dispositif (connu sous l'expression anglo-saxonne de « boat ») destiné à soutenir la structure dans le four.

On relèvera en outre que ce phénomène de dégradation de la qualité de la couche mince (par exemple du fait de la génération de lignes de glissement) est amplifié lorsque le recuit de stabilisation est combiné avec d'autres traitements thermiques (par exemple avec un recuit thermique rapide comme cela est proposé dans le document US2005/0042840). Une telle combinaison engendre en effet une succession de contraintes d'origine thermique, qui finalement se combinent pour dégrader la qualité de la couche mince.

Il existe donc un besoin pour une technique alternative au recuit de stabilisation post-détachement réalisé en four à une température d'au moins 1000°C pendant plusieurs heures, et plus précisément pour une technique qui permette de stabiliser l'interface de collage entre une couche mince et un substrat support sur lequel ladite couche mince a été transférée sans pour autant présenter les inconvénients susmentionnés.

Le document WO 03/005434 propose de réaliser un traitement thermique post-détachement sous la forme d'un unique recuit thermique rapide RTA afin de réduire la rugosité de surface d'une structure couche mince sur substrat support. Ce traitement thermique n'est aucunement présenté comme permettant de réaliser une stabilisation de l'interface de collage entre la couche mince et le substrat support.

Dans des variantes de réalisation, ce document WO 03/005434 propose de réaliser, en sus du recuit RTA de lissage, une opération de polissage et une ou plusieurs opérations d'oxydations sacrificielles pour retirer les défauts restant éventuellement après l'étape de polissage. Et ce document précise que les traitements thermiques associés aux opérations d'oxydations sacrificielles et effectués au moins en partie à une température supérieure à 1000°C permettent de renforcer l'interface de collage. Ce document ne fait donc pas état d'une stabilisation du collage (phénomène microscopique), mais d'un simple renfort du collage (phénomène macroscopique). Et on constatera également que ce document ne décrit ni ne suggère qu'un tel traitement thermique apte (simplement) à renforcer le collage puisse prendre la forme d'un RTA.

Le document US 2005/0014346 fait état d'un recuit de collage et de détachement apte à renforcer l'énergie de collage. Ce recuit n'est toutefois pas appliqué à la structure obtenue après détachement. Il n'est en outre aucunement présenté comme étant apte à stabiliser l'interface de collage.

Ce document US 2005/0014346 mentionne un traitement de réduction de la rugosité de surface post-détachement, par exemple sous la forme d'un recuit RTA. Mais, tout comme le document WO 03/005434, il n'est aucunement précisé ni suggéré que ce traitement puisse permettre de stabiliser l'interface de collage.

L'invention a pour objectif de répondre au besoin susmentionné, et propose à cet effet un procédé de réalisation d'une structure comprenant une couche mince de matériau semi-conducteur sur un substrat, comportant les étapes de :
- création d'une zone de fragilisation dans l'épaisseur du substrat donneur;
- collage du substrat donneur avec un substrat support ;
- détachement du substrat donneur au niveau de la zone de fragilisation, pour transférer une partie du substrat donneur sur le substrat support et former la couche mince sur celui-ci ;
- traitement thermique de la structure obtenue après détachement pour stabiliser l'interface de collage entre la couche mince et le substrat support ;
**caractérisé en ce que** l'étape de traitement thermique de stabilisation de l'interface de collage est réalisée par mise en oeuvre d'une ou plusieurs opérations de recuit thermique rapide.

Certains aspects préférés, mais non limitatifs, de ce procédé sont les suivants :
- il comporte en outre après détachement une étape d'amincissement de la couche mince ;
- l'étape d'amincissement est mise en oeuvre après la première de la ou des opération(s) de recuit thermique rapide ;
- l'étape d'amincissement comprend une opération de traitement thermique réalisée à une température inférieure ou égale à 1000°C ;
- l'opération thermique de l'étape d'amincissement est une oxydation de la structure obtenue après détachement réalisée à une température comprise entre 800°C et 1000°C, de préférence à 950°C ;
- suite à l'oxydation de la structure obtenue après détachement, on réalise une désoxydation pour retirer la couche d'oxyde formée lors de l'opération d'oxydation ;
- l'étape de traitement thermique de stabilisation de l'interface de collage est réalisée par mise en oeuvre d'au moins deux opérations de recuit thermique rapide, et l'étape d'amincissement est réalisée entre lesdites deux opérations de recuit thermique rapide ;
- une opération de recuit rapide est réalisée en soumettant la structure obtenue après détachement à une température sensiblement comprise entre 1200 et 1250°C pendant une durée sensiblement comprise entre 5 et 60 secondes ;
- il comporte en outre une étape réalisée avant détachement de renforcement de l'énergie de collage, et l'étape de traitement thermique de stabilisation de l'interface de collage est réalisée par mise en oeuvre d'au moins une opération de recuit thermique rapide ;
- l'étape de renforcement de l'énergie de collage est mise en oeuvre avant collage et consiste en un traitement plasma de l'une et/ou l'autre des surfaces à coller ;
- la durée d'exposition au plasma est comprise entre 5 et 60 secondes, et est préférentiellement d'environ 30 secondes ;
- le plasma est initié et entretenu par application d'une puissance radiofréquence par unité de surface comprise entre 150 et 2800 mW/cm², et préférentiellement d'environ 750 mW/cm² ;
- l'opération de recuit rapide est réalisée en soumettant la structure obtenue après détachement à une température sensiblement égale à 1200°C pendant une durée comprise entre 5 et 60 secondes, préférentiellement d'environ 30 secondes ;
- hormis pour la ou les opérations de recuit thermique rapide, la température est maintenue en-dessous de 1000°C, et de préférence en-dessous de 950°C.

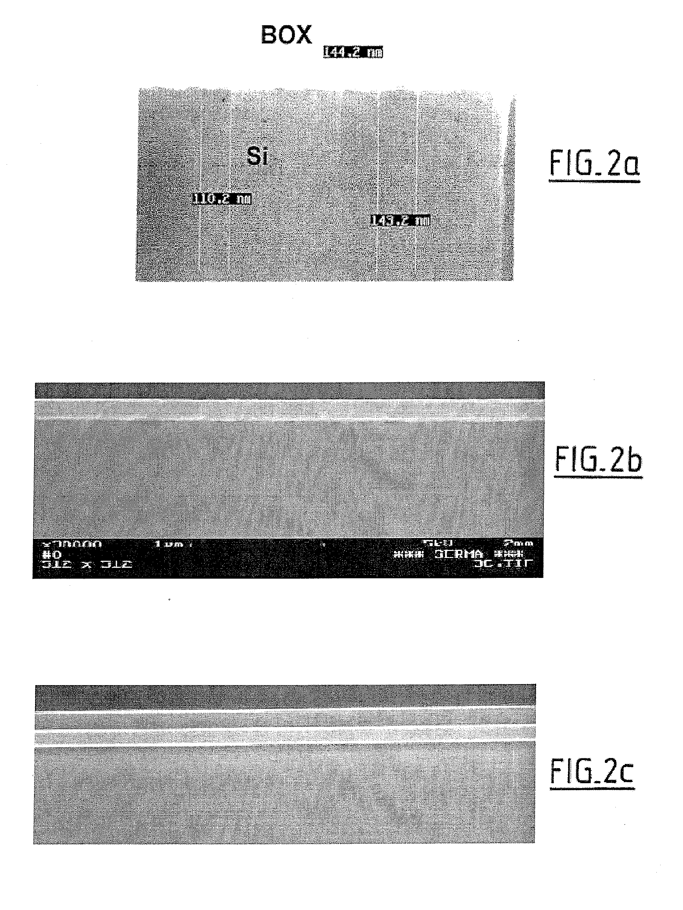

D'autres aspects, buts et avantages de la présente invention apparaîtront mieux à la lecture de la description détaillée suivante de formes de réalisation préférées de celle-ci, donnée à titre d'exemple non limitatif, et faite en référence aux dessins annexés sur lesquels, outre les figures 1a et 1b déjà discutées précédemment, la figure 2a illustre l'interface de collage stabilisée par mise en oeuvre du recuit classique de stabilisation, tandis que les figures 2a-2c illustrent chacune l'interface de collage stabilisée par mise en oeuvre d'un mode de réalisation possible du procédé selon l'invention.

Comme cela a déjà été exposé précédemment, l'invention concerne la réalisation de structures comprenant une couche mince de matériau semi-conducteur sur un substrat support, la couche mince étant obtenue par détachement au niveau d'un substrat donneur dans l'épaisseur duquel on a préalablement créée une zone de fragilisation.

La zone de fragilisation peut être créée dans l'épaisseur du substrat donneur à une profondeur voisine ou supérieure à l'épaisseur de la couche mince à transférer par implantation d'espèces atomiques ou par formation d'une couche poreuse, ou encore par toute autre méthode apte à fragiliser localement les liaisons mécaniques dans le substrat donneur.

Le collage est ensuite réalisé, par mise en contact intime et adhésion moléculaire du substrat donneur avec le substrat support.

Puis le substrat donneur est détaché au niveau de la zone de fragilisation, typiquement par apport d'énergie thermique et/ou mécanique, pour transférer une partie du substrat donneur sur le substrat support et former la couche mince sur celui-ci.

Le procédé selon l'invention comporte en outre une étape de traitement thermique de la structure obtenue après détachement pour stabiliser l'interface de collage entre la couche mince et le substrat support.

L'invention vise plus précisément une technique permettant de stabiliser l'interface de collage, sans pour autant recourir à un recuit de stabilisation, c'est-à-dire à un recuit en four à une température d'au moins 1000°C pendant plusieurs heures.

L'invention propose à cet effet de réaliser l'étape de traitement thermique de stabilisation de l'interface de collage par mise en oeuvre après détachement d'une ou plusieurs opérations de recuit thermique rapide de type RTA (correspondant à l'acronyme de l'expression anglo-saxonne « Rapid Thermal Annealing »).

La Demanderesse a effectivement pu constater que de manière particulièrement surprenante, il est possible de stabiliser l'interface de collage en réalisant l'étape de traitement thermique de stabilisation sur une durée nettement plus courte que celle que l'on considérait jusqu'à présent nécessaire (typiquement recuit à une température supérieure à 1000°C pendant une durée supérieure à 30 minutes).

On rappelle ici que par interface stabilisée au sens de la présente invention, on entend ici une interface présentant des défauts microscopiques suite à une gravure Wright en une densité inférieure à une densité limite, typiquement prise à 1 défaut/champ (de 3µm de large) observé au microscope MEB.

Dans le cadre de la présente invention, le recuit rapide peut être réalisé dans un four de type de ceux classiquement utilisés pour réaliser un RTA. Le recuit rapide peut également être réalisé dans un bâti d'épitaxie.

Le recuit rapide est effectué sous atmosphère contrôlée. Il peut s'agir d'une atmosphère comprenant un mélange d'hydrogène et d'argon, d'une une atmosphère d'argon pur, d'hydrogène pur, voire même d'une atmosphère comprenant de l'acide chlorhydrique.

D'une manière générale, l'opération de RTA est mise en oeuvre de manière à présenter un budget thermique (couple durée/température) supérieur à un budget minimal. La température du RTA doit ainsi être typiquement maintenue supérieure à 1000°C pendant environ quelques secondes à quelques minutes.

L'étape de stabilisation est préférentiellement réalisée conjointement avec une étape, réalisée après détachement, d'amincissement de la couche mince.

Cette étape d'amincissement permet en particulier de réduire l'épaisseur de la couche mince transférée sur le substrat support, pour l'amener à l'épaisseur désirée pour la structure finale.

Par ailleurs, on notera qu'outre la fonction d'amincissement à proprement parler, l'étape d'amincissement permet également de préparer la surface de la couche mince en vu de son lissage, en particulier lors d'une opération RTA subséquente.

L'étape d'amincissement est préférentiellement, mais non exclusivement, mise en oeuvre après l'étape de traitement thermique de stabilisation.

L'étape d'amincissement est préférentiellement mise en oeuvre en réalisant un traitement thermique d'oxydation de la couche mince (on forme alors une couche d'oxyde sur la couche mince), puis en réalisant une opération de désoxydation (pour retirer la couche d'oxyde formée lors de l'oxydation ; par exemple en plongeant la structure pendant quelques minutes, dans une solution d'acide fluorhydrique à 10% ou 20%).

L'oxydation est réalisée en chauffant la structure sous oxygène gazeux par exemple. En tout état de cause, l'oxydation thermique est réalisée à une température inférieure ou égale à 1000°C ; par exemple à une température comprise entre 800°C et 1000°C, de préférence à une température de 950°C.

On relèvera que le fait de réaliser l'amincissement à une température inférieure ou égale à 1000°C permet de limiter la génération de lignes de glissement.

L'étape d'amincissement n'est pas limité au mode de réalisation oxydation/désoxydation ; elle peut également être réalisée d'autres manières : par exemple en réalisant une gravure sèche de la couche mince, en mettant en oeuvre des recuits dans une atmosphère de gravure (par exemple HCl) à des températures inférieures ou égales à 1000°C.

Selon un premier mode de réalisation préféré du procédé selon l'invention, le recuit de stabilisation longue durée est remplacé par la réalisation d'au moins deux opérations de recuit thermique rapide RTA.

Plus précisément, on met ici en oeuvre deux opérations RTA à une température plus élevée que la température à laquelle on réalise classiquement le recuit de stabilisation.

Prenant l'exemple de la stabilisation d'une interface de collage SiO₂/Si réalisée classiquement en exposant la structure obtenue post-détachement à une température de 1100°C pendant deux heures, on réalise dans le cadre de l'invention deux opérations RTA, chacune d'une durée de 30 secondes, et à une température de 1200°C.

On notera toutefois que l'invention n'est pas limitée à ce budget thermique (30s/1200°C) pour chacune des opérations RTA, mais concerne également la réalisation d'opérations RTA :
- à des températures supérieures à 1200°C, typiquement jusqu'à environ 1250°C ; et/ou
- d'une durée supérieure à 5 secondes, typiquement jusqu'à 60 secondes.

Dans le cadre d'une variante préférentielle de ce premier mode de réalisation, on réalise l'étape d'amincissement de la couche mince entre chaque opération RTA. L'amincissement est ici réalisé par la mise en oeuvre d'une oxydation thermique à une température inférieure ou égale à 1000°C suivie d'une désoxydation.

Selon un second mode de réalisation préféré du procédé selon l'invention, l'étape de recuit de stabilisation est remplacée par la mise en oeuvre conjointe :
- d'une étape de renforcement de l'énergie de collage réalisée avant détachement, et
- d'une étape de stabilisation de l'interface de collage réalisée par mise en oeuvre après détachement d'au moins une opération de recuit thermique rapide.

De préférence, l'étape de renforcement de l'énergie de collage est mise en oeuvre avant collage et consiste en un traitement plasma de l'une et/ou l'autre des surfaces à coller.

Ainsi, dans le cadre de cette variante, le substrat donneur (oxydé ou non de manière à former une couche d'oxyde servant de couche isolante intercalée entre la couche mince et le substrat support) et/ou le substrat donneur (oxydé ou non pour les mêmes raisons) est (sont) exposé(s) à un plasma, avant la mise en contact intime des faces à coller.

La durée d'exposition au plasma est comprise entre 5 et 60 secondes ; elle est typiquement d'environ 30 secondes.

Des équipements classiquement utilisés en microélectronique pour réaliser une gravure sèche peuvent être utilisés afin de mettre en oeuvre cette étape de traitement plasma. Il s'agit notamment d'un équipement permettant de réaliser une gravure de type RIE (selon l'acronyme anglo-saxon « Reactive Ion Etching » pour Gravure Ionique Réactive).

Le traitement plasma peut être pratiqué dans une enceinte sous vide, voire même à pression atmosphérique.

Un gaz pur (typiquement O₂, et éventuellement N₂, He ou Ar), ou un mélange gazeux est introduit dans l'enceinte, avec un débit de l'ordre de 50 à 500sccm, de manière à établir une pression comprise entre 10 et 200 mTorr (typiquement 50 mTorr).

Le plasma peut être initié puis entretenu par application d'une puissance radiofréquence par unité de surface comprise dans la gamme 150-2800 mW/cm², et typiquement de l'ordre de 750 mW/cm² (soit dans la gamme 100-2000 W, et typiquement de l'ordre de 500 W, pour un substrat sous la forme d'une plaquette de 300 mm de diamètre).

Le traitement plasma permet de stabiliser plus facilement l'interface de collage en température. Ainsi, dans le cas où un traitement plasma de l'une et/ou l'autre des surfaces à coller est mis en oeuvre avant collage selon les conditions indiquées précédemment, l'étape de traitement thermique de stabilisation de l'interface de collage peut consister en la réalisation d'un recuit thermique rapide du type RTA à 1200°C, pendant une durée comprise entre 5 et 60 secondes, typiquement d'environ 30 secondes.

Dans le cadre d'une variante préférentielle de ce second mode de réalisation, on réalise l'étape d'amincissement de la couche mince après l'opération RTA. L'amincissement est ici réalisé par la mise en oeuvre d'une oxydation thermique à une température inférieure ou égale à 1000°C suivie d'une désoxydation.

Revenant à la description générale du second mode de réalisation, on constate que la mise en oeuvre, avant détachement, d'une étape de renforcement de l'énergie de collage a un impact sur l'aptitude à stabiliser facilement l'interface de collage par le biais d'une étape de recuit thermique rapide réalisée post-détachement.

Il est donc possible de réaliser un recuit RTA dont le budget thermique est plus faible qu'un recuit RTA réalisé dans le cadre du premier mode de réalisation. Le recuit RTA du deuxième mode de réalisation peut ainsi être plus rapide (cas de l'exemple présenté ci-dessus) ou réalisé à plus basse température qu'un recuit RTA du premier mode de réalisation.

Par ailleurs, il est possible dans le cadre de ce second mode de réalisation de stabiliser fortement l'interface de collage en réalisant un nombre d'opérations de recuit thermique rapide inférieur au nombre d'opérations nécessaire dans le cadre du premier mode de réalisation. On peut typiquement ne réaliser qu'une seule opération RTA dans le cadre du second mode de réalisation lorsque deux opérations RTA s'avèrent nécessaires dans le cadre du premier mode de réalisation pour stabiliser fortement l'interface de collage.

A ce titre, les figures 2a-2c illustrent la stabilisation de l'interface de collage et représentent respectivement :
- figure 2a : une interface Oxyde/Silicium fortement stabilisée par la mise en oeuvre d'un recuit classique de stabilisation de deux heures à 1100°C (similaire à la figure 1 a) ;
- figure 2b : une interface Oxyde/Silicium faiblement stabilisée par la mise en oeuvre, conformément à la variante préférentielle du premier mode de réalisation, de deux opérations RTA, à une température de 1200°C pendant 30 secondes, entre lesquelles est intercalée une étape d'amincissement réalisée par voie d'oxydation thermique à une température inférieure ou égale à 1000°C ;
- figure 2c : une interface Oxyde/Silicium fortement stabilisée par la mise en oeuvre, conformément à la variante préférentielle du second mode de réalisation, d'un renforcement pré-détachement de l'énergie de collage sous la forme d'un traitement plasma et de la séquence post-détachement RTA (1200°C/30 secondes) et amincissement voie d'oxydation thermique à une température inférieure ou égale à 1000°C.

On constate sur la figure 2b que la stabilisation de l'interface de collage (telle que révélée par gravure Wright) n'est pas parfaite: une faible densité de défauts peut effectivement être détectée. Toutefois, cette faible présence de défauts n'est pas préjudiciable dans la mesure où la stabilisation obtenue s'avère satisfaisante dans les domaines d'application de l'invention.

On précise pour finir que les opérations réalisées après détachement (telles que les opérations des séquences préférentielles RTA/amincissement/RTA et plasma + RTA/amincissement), peuvent être complétées par la réalisation d'étapes supplémentaires (par exemple des étapes supplémentaires d'amincissement, typiquement sous la forme oxydation/désoxydation) toujours réalisées à une température inférieure ou égale à 1000°C.

On aura ainsi compris que dans le procédé selon les différents modes de réalisation possible de l'invention, aucune étape, hormis la ou les étapes de recuit thermique de stabilisation de l'interface de collage, n'est mise en oeuvre à une température supérieure à 1000°C. De préférence, on limite même la température de ces autres étapes à une température n'excédant pas 950 °C.

Ainsi, la température est maintenue en dessous de 1000°C, de préférence en dessous de 950°C, pour l'ensemble des étapes du procédé autres que la ou les étapes de recuit thermique de stabilisation de l'interface de collage. En particulier est ainsi exclue du procédé la réalisation, en sus du ou des étapes de recuit thermique de stabilisation de l'interface de collage, d'oxydations thermiques ou de traitements thermiques à des températures supérieures à 1000°C.

## Revendications

1. Procédé de réalisation d'une structure comprenant une couche mince de matériau semi-conducteur sur un substrat, comportant les étapes de:
- création d'une zone de fragilisation dans l'épaisseur du substrat donneur;
- collage du substrat donneur avec un substrat support ;
- détachement du substrat donneur au niveau de la zone de fragilisation, pour transférer une partie du substrat donneur sur le substrat support et former la couche mince sur celui-ci ;
- traitement thermique de la structure obtenue après détachement pour stabiliser l'interface de collage entre la couche mince et le substrat support ;
**caractérisé en ce que** l'étape de traitement thermique de stabilisation de l'interface de collage est réalisée par mise en oeuvre d'une ou plusieurs opérations de recuit thermique rapide.

2. Procédé selon la revendication précédente, **caractérisé en ce qu'**il comporte en outre après détachement une étape d'amincissement de la couche mince.

3. Procédé selon la revendication précédente, **caractérisé en ce que** l'étape d'amincissement est mise en oeuvre après la première de la ou des opération(s) de recuit thermique rapide.

4. Procédé selon l'une des deux revendications précédentes, **caractérisé en ce que** l'étape d'amincissement comprend une opération de traitement thermique réalisée à une température inférieure ou égale à 1000°C.

5. Procédé selon la revendication précédente, **caractérisé en ce que** l'opération thermique de l'étape d'amincissement est une oxydation de la structure obtenue après détachement réalisée à une température comprise entre 800°C et 1000°C, de préférence à 950°C.

6. Procédé selon la revendication précédente, **caractérisé en ce que** suite à l'oxydation de la structure obtenue après détachement, on réalise une désoxydation pour retirer la couche d'oxyde formée lors de l'opération d'oxydation.

7. Procédé selon l'une des revendications 2 à 6, **caractérisé en ce que** l'étape de traitement thermique de stabilisation de l'interface de collage est réalisée par mise en oeuvre d'au moins deux opérations de recuit thermique rapide, et **en ce que** l'étape d'amincissement est réalisée entre lesdites deux opérations de recuit thermique rapide.

8. Procédé selon la revendication précédente, **caractérisé en ce qu'**une opération de recuit rapide est réalisée en soumettant la structure obtenue après détachement à une température sensiblement comprise entre 1200 et 1250°C pendant une durée sensiblement comprise entre 5 et 60 secondes.

9. Procédé selon l'une des revendications 2 à 6, **caractérisé en ce qu'**il comporte en outre une étape réalisée avant détachement de renforcement de l'énergie de collage, et **en ce que** l'étape de traitement thermique de stabilisation de l'interface de collage est réalisée par mise en oeuvre d'au moins une opération de recuit thermique rapide.

10. Procédé selon la revendication précédente, **caractérisé en ce que** l'étape de renforcement de l'énergie de collage est mise en oeuvre avant collage et consiste en un traitement plasma de l'une et/ou l'autre des surfaces à coller.

11. Procédé selon la revendication précédente, **caractérisé en ce que** la durée d'exposition au plasma est comprise entre 5 et 60 secondes, et est préférentiellement d'environ 30 secondes.

12. Procédé selon l'une des deux revendications précédentes, **caractérisé en ce que** le plasma est initié et entretenu par application d'une puissance radiofréquence par unité de surface comprise entre 150 et 2800 mW/cm², et préférentiellement d'environ 750 mW/cm².

13. Procédé selon l'une quelconque des revendications 9 à 12, **caractérisé en ce que** l'opération de recuit rapide est réalisée en soumettant la structure obtenue après détachement à une température sensiblement égale à 1200°C pendant une durée comprise entre 5 et 60 secondes, préférentiellement d'environ 30 secondes.

14. Procédé selon l'une quelconque des revendications précédentes, **caractérisé en ce que**, hormis pour la ou les opérations de recuit thermique rapide, la température est maintenue en-dessous de 1000°C, et de préférence en-dessous de 950°C.
